Europäisches Patentamt

European Patent Office

Office européen des brevets

(11) Publication number: 0 372 505
A2

## (12) EUROPEAN PATENT APPLICATION

(21) Application number: 89122453.7

(22) Date of filing: 06.12.89

(51) Int. Cl.⁵: B32B 15/14, B32B 27/04, B32B 31/08

(30) Priority: 07.12.88 US 281012

(43) Date of publication of application:
13.06.90 Bulletin 90/24

(84) Designated Contracting States:
AT BE CH DE ES FR GB GR IT LI LU NL SE

(71) Applicant: PHILLIPS PETROLEUM COMPANY
5th and Keeler
Bartlesville Oklahoma 74004(US)

(72) Inventor: O' Connor, James Edward
5908 Martin Place
Bartlesville, OK 74006(US)
Inventor: Bonazza, Benedict Rocco
6432 Baylor Drive
Bartlesville, OK 74006(US)
Inventor: Webster, James Thomas
1729 Orchard Lane
Bartlesville, OK 74006(US)

(74) Representative: Geissler, Bernhard, Dr. jur.,
Dipl.-Phys. Patent- und Rechtsanwälte et al
Bardehle-Pagenberg-Dost-
Altenburg-Frohwitter-Geissler & Partner
Postfach 86 06 20
D-8000 München 86(DE)

(54) Method for producing reinforced thermoplastic composite-metallic foil laminated articles.

(57) A method of continuously producing fiber reinforced thermoplastic composite-metallic foil laminated articles is provided. A continuous fiber reinforcing material impregnated with a thermoplastic material and at least one adjacently positioned continuous metallic foil are pulled through a heated forming die whereby a continuous laminate comprised of a fiber reinforced thermoplastic composite having metal foil adhered thereto is formed.

FIG. 1

# METHOD OF PRODUCING REINFORCED THERMOPLASTIC COMPOSITE-METALLIC FOIL LAMINATED ARTICLES

## Background of the Invention

### 1. Field of the Invention

The present invention relates generally to a method of producing reinforced thermoplastic composite-metallic foil laminated articles, and more particularly, to such a method wherein the laminated articles are continuously formed by pultrusion.

### 2. Description of the Prior Art

The production of molded thermoplastic products reinforced with fibrous reinforcing material by pultrusion is known. In the thermoplastic pultrusion process, one or more continuous fiber strands, tapes or sheets impregnated with a thermoplastic material are pulled through a heated composite forming die assembly wherein the thermoplastic material is melted and formed into a desired shape. The thermoplastic material-fiber composite is then cooled by pulling through a cooling die and cut into a plurality of articles of desired length.

Recently, reinforced thermoplastic composites have been utilized as substrates in the fabrication of printed circuit boards. A metallic foil such as copper foil is adhered to one or both sides of the composite, or a laminate comprised of several layers of composite with metallic foil in between as well as on the outside surfaces is produced. The printed circuit is then formed in the metallic foil using known techniques.

United States Patent No. 4,395,459 discloses a process of producing reinforced laminates from crosslinkable thermoplastic olefin polymer materials. A sheet of metallic foil, such as copper foil, can be applied to a surface of the laminate prior to heating and crosslinking the laminate. A continuous sheet of the reinforced laminate can be formed by extrusion, by calendering or by pultrusion.

United States Patent No. 4,389,453 is directed to a molded board formed of poly(phenylene sulfide) thermoplastic material reinforced with glass fibers. The molded board is used in the production of circuit boards by bonding a metallic foil to a surface thereof. A continuous process for forming the molded board with metallic foil adhered thereto is disclosed wherein a mixture or assembly of the thermoplastic material and glass fiber material is introduced between a pair of metal belts along with the metallic foil. While being moved by the metal belts, the assembly is continuously heated and then cooled under pressure to form a composite molded board having a metallic foil bonded to a surface thereof.

By the present invention an improved method of producing fiber reinforced thermoplastic composite articles having metallic foil adhered thereto which can be utilized in the production of circuit boards is provided. In accordance with the method, a continuous composite-metal foil laminate is formed by pultrusion, and then cut into articles of desired length.

## Summary of the Invention

A method of producing a fiber reinforced thermoplastic composite-metallic foil laminate is provided wherein a continuous fiber reinforcing material impregnated with a thermoplastic material and at least one adjacently positioned continuous metallic foil are pulled through a heated forming die. The heated forming die has a temperature such that the thermoplastic material is in the molten state. As a result, the reinforcing material and thermoplastic material are formed into a composite laminate while passing through the die, and the metallic foil is simultaneously bonded to the formed composite within the die.

The method preferably includes the step of pulling the laminate exiting the heated forming die through a cooling die so that the laminate is cooled to a desired temperature. The cooled laminate can then be processed further such as by cutting it into articles of determined length.

The continuous reinforced thermoplastic composite-metallic foil laminate and the articles produced therefrom can be comprised of a single reinforced thermoplastic composite layer having a metal foil adhered to one or both sides thereof, or the laminate and articles can be comprised of several reinforced thermoplastic composite layers with metallic foil disposed between the layers and adhered to the top and bottom surfaces of the laminate.

It is, therefore, a general object of the present invention to provide an improved method of producing reinforced thermoplastic composite-metallic foil laminated articles.

A further object of the present invention is the provision of an improved method of continuously forming a reinforced thermoplastic composite-metallic foil laminate by pultrusion.

Other and further objects, features and advantages of the present invention will be readily apparent to those skilled in the art upon a reading of the description of preferred embodiments which follows when taken in conjunction with the accompanying drawings.

## Brief Description of the Drawings

FIGURE 1 is a schematic illustration of a system of apparatus for carrying out the method of the present invention.

FIGURE 2 is an enlarged side view of the heated forming die and cooling die shown in FIGURE 1.

FIGURE 3 is a top view of the heated forming die and cooling die of FIGURE 2.

FIGURE 4 is a perspective view of a reinforced thermoplastic composite-metallic foil laminated article produced in accordance with the present invention.

FIGURE 5 is a perspective view of an alternate reinforced thermoplastic composite-metallic foil laminated article which can be produced in accordance with the present invention.

FIGURE 6 is a perspective view of yet another reinforced thermoplastic composite-metallic foil laminated article produced in accordance with the present invention.

## Description of Preferred Embodiments

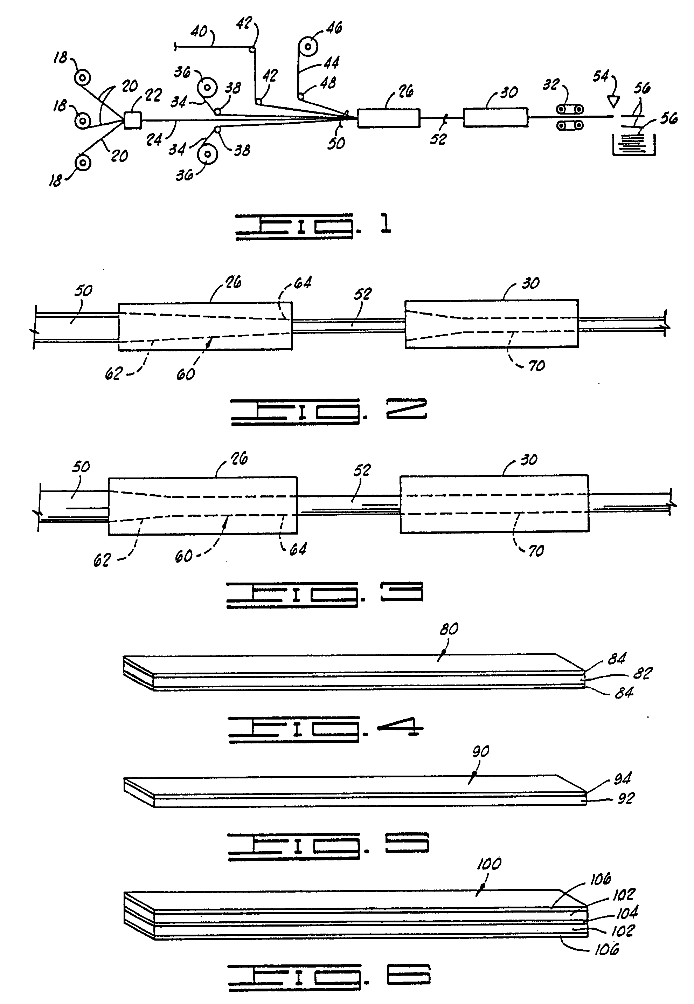

Referring now to the drawings, and particularly to FIGURE 1, a pultrusion system for carrying out the method of the present invention is illustrated and generally designated by the numeral 10. The system 10 includes creels 18 from which one or more continuous tapes or sheets 20 of thermoplastic impregnated reinforcing fiber are drawn and passed through a guiding system 22.

The reinforcing fibers of the tapes or sheets 20 are preferably selected from the group consisting of glass fibers, carbon fibers and aramid fibers. Of these, glass fibers are presently preferred. The form of the fibers can be continuous, aligned, unidirectional fibers, woven fabric formed of continuous or chopped fibers or random mat formed of continuous or chopped fibers.

A variety of thermoplastic materials can be utilized. Examples of such thermoplastic materials are poly(arylene sulfide), polysulfone, polyimide, polyetherimide, polyetherketone and polyetheretherketone. Of these, poly(arylene sulfide) thermoplastic materials are preferred, with poly(phenylene sulfide) being the most preferred.

The term poly(arylene sulfide) includes homopolymers and the normally solid arylene sulfide copolymers, terpolymers and the like having melting or softening points of at least about 150°C, and more preferably from about 200°C to about 500°C. Examples of poly(arylene sulfide) thermoplastic materials are poly(phenylene sulfide), poly-(4,4′-biphenylene sulfide), poly(phenylene sulfide sulfone), poly(phenylene sulfide ketone), poly(2,4-toluene sulfide), a copolymer of p-dichlorobenzene, 2,4-dichlorotoluene and sodium sulfide, the polymer from bis-4,4′-(4-chlorophenyl sulfenyl)biphenyl and sodium sulfide, copolymers of these materials, and the like.

The tapes or sheets of thermoplastic impregnated reinforcing fiber 24 from a supply of pre-impregnated reinforcing material as illustrated in FIGURE 1 or, alternatively, from apparatus for impregnating fiber with thermoplastic material (not shown), are pulled through a heated forming die 26 and a cooling die 30 by a continuous pulling mechanism 32. Prior to when the impregnated tapes or sheets 24 reach the heated forming die 26, one or more tapes or sheets of metallic foil 34 are drawn from rolls 36 and positioned by redirect bars 38 adjacent one or both sides of the impregnated tapes or sheets 24. As will be described further hereinbelow, when laminated articles having two thermoplastic composite layers separated by metallic foil are produced, additional tapes or sheets of thermoplastic impregnated reinforcing fiber 40 from a second supply of pre-impregnated reinforcing material (not shown) or, alternatively, from an apparatus for impregnating fiber with thermoplastic material (not shown), are positioned adjacent one of the tapes or sheets of metallic foil 34 by redirect bars 42. An additional tape or sheet of metallic foil 44 from a roll 46 is positioned adjacent the tapes or sheets of impregnated fibers 40 by a redirect bar 48. As will be understood, additional thermoplastic impregnated reinforcing fiber and additional metallic foil can be utilized. The resulting continuous lay-up 50 comprised of one or more continuous tapes or sheets of reinforcing fibers impregnated with thermoplastic material with one or more continuous tapes or sheets of metallic foil positioned adjacent thereto is pulled by the pulling mechanism 32 through the heated forming die 26 and cooling die 30.

Examples of electric conductive metallic foils which can be used in carrying out the method of this invention for producing laminates useful in the production of printed circuit boards are copper foil, aluminum foil and silver foil. Of these, copper foil is preferred. However, it is to be understood that other metallic foils can be used, and the laminates produced therewith can be used in a variety of other applications. In order to insure that the metallic foil is tightly bonded to the thermoplastic material when the thermoplastic material solidifies, the side or sides of the foil to be bonded are preferably treated whereby a rough surface is formed thereon to which the thermoplastic material will readily adhere.

As is well understood by those skilled in the art, the heated forming die 26 can be comprised of several components in series including guide, preshaping, preheating and forming apparatus. The term "heated forming die" as hereinafter used is intended to be inclusive of such guide, preshaping, preheating and heated forming apparatus. The heated forming die 26 has a temperature whereby the thermoplastic material reaches the molten state while passing therethrough. For example, when the thermoplastic material is poly(phenylene sulfide), the temperature within the heated forming die 26 is such that the temperature of the thermoplastic material being pulled therethrough reaches a high temperature in the range of from about 350°C to about 400°C.

As a result of the heating and forming of the lay-up 50 of thermoplastic material impregnated fibers and metallic foil pulled through the heated forming die 26, a laminate 52 comprised of a fiber reinforced thermoplastic composite having a metal foil adhered to at least one side thereof is produced. The laminate 52 exiting the heated forming die 26 is pulled through the cooling die 30 so that it is cooled to a relatively low handling temperature, e.g., a temperature in the range of from about 80°C to about 100°C. The laminate 52 then passes through the pulling mechanism 32 and is forwarded to a cutting device 54 which cuts it into a plurality of articles 56 of determined length.

Referring now to FIGURES 2 and 3, the heated forming die 26 and cooling die 30 through which the lay-up 50 and laminate 52 are pulled, respectively, are illustrated in greater detail. The heated forming die 26 is elongated and includes a single die cavity 60 having taper from the entrance end which decreases in cross-sectional area to a final desired opening 64 at the exit end. In order to heat the die 26 and maintain the desired temperature therein, the die 26 is conventionally equipped with electric strip heaters or cartridge heaters (not shown) and a plurality of thermocouples (not shown) for measuring the temperature throughout the length of the die. The electric strip heaters or cartridge heaters and the thermocouples are connected to conventional electric control apparatus. The temperature within the die cavity 60 of the heated forming die 26 is maintained at a level such that the thermoplastic material in the lay-up 50 reaches the molten state while passing therethrough.

In an alternate embodiment, the die 26 can have a temperature gradient whereby the thermoplastic material in the lay-up 50 reaches the molten state in the entrance region of the die and is cooled while being formed to a solidified state in the exit region thereof. In such embodiment, the temperature of the poly(phenylene sulfide) thermoplastic material ranges from a high of from about 350°C to about 400°C to a low of from about 230°C to about 280°C. When the heated forming die 26 has a temperature gradient as described above, the cooling die 30 can be omitted if desired.

The melting of the thermoplastic material and the forming and compression thereof along with the metallic foil and reinforcing material while passing through the die 26 bring about the consolidation of the reinforced thermoplastic composite and the bonding of the metal foil thereto. The resulting laminate 52 exiting the heated forming die 26 passes through the cooling die 30 wherein it is solidified and cooled to a relatively low temperature at which the laminate can be handled, i.e., a temperature in the range of from about 80°C to about 100°C. The die cavity 70 of the cooling die 30 is tapered at the entrance end thereof for a small distance. The major portion of the die cavity 70 to the exit end thereof is of substantially the same shape and cross-sectional area as the exit 64 of the die cavity 60 of the heated forming die 26. The cooling die 30 is cooled by the circulation of a cooling medium through passageways formed therein (not shown). As indicated above, from the cooling die 30, the laminate 52 passes through the pulling mechanism 32 and is cut into articles of determined length by the cutting means 54.

Referring now to FIGURE 4, a laminated article produced in accordance with the method of the present invention is illustrated and generally designated by the numeral 80. The article 80 is rectangular in shape and is comprised of a fiber reinforced thermoplastic composite substrate 82 having metallic foils 84 adhered to both sides thereof. This form of article is commonly utilized in the production of printed circuit boards, and is produced in the system 10 by a lay-up 50 comprised of a single layer of thermoplastic impregnated reinforcing fiber with metallic foils positioned on both sides thereof.

Referring to FIGURE 5, an alternate laminated article of the present invention is illustrated and designated by the numeral 90. The article 90 is comprised of a single reinforced thermoplastic composite substrate 92 having a metallic foil 94 adhered to one side thereof. The article 90 can also be utilized in the fabrication of printed circuit boards, and is produced in the system 10 by a lay-up 50 comprised of a single layer of thermoplastic impregnated reinforcing fibers with a metallic foil positioned adjacent one side thereof.

Referring to FIGURE 6, yet another laminated article of the present invention is illustrated and generally designated by the numeral 100. The article 100 can also be used in the fabrication of circuit boards, and is comprised of a pair of reinforced thermoplastic composite substrates 102 having a metallic foil 104 adhered therebetween and metallic foils 106 adhered to both sides thereof. The laminated article 100 is produced in the system 10 by a lay-up 50 comprised of two layers of thermoplastic impregnated reinforcing fibers separated by a metal foil with additional foils positioned above and below the impregnated fibrous material layers.

The present invention, therefore, is well adapted to carry out the objects and to attain the ends and advantages mentioned as well as those inherent therein. While presently preferred embodiments are described for purposes of this disclosure, numerous changes in the construction and arrangement of parts will readily suggest themselves to those skilled in the art, which changes are encompassed within the spirit of this invention as defined by the appended claims.

**Claims**

1. A method of producing a fiber reinforced thermoplastic composite-metallic foil laminate comprising pulling a fiber reinforcing material impregnated with a thermoplastic material and an adjacently positioned metallic foil through a heated forming die having a temperature such that said thermoplastic material reaches the molten state while passing therethrough whereby a laminate comprised of a fiber reinforced thermoplastic composite having a metal foil adhered thereto is formed.

2. The method of claim 1 wherein the entrance cross section of said heated forming die is larger than the exit cross section thereof.

3. The method of one of the preceding claims wherein said thermoplastic material is selected from the group consisting of poly(arylene sulfide), polysulfone, polyimide, polyetherimide, polyetherketone and polyetheretherketone.

4. The method of one of the preceding claims wherein said fiber reinforcing material is formed of fibers selected from the group consisting of glass fibers, carbon fibers and aramid fibers.

5. The method of one of the preceding claims wherein said metallic foil is selected from the group consisting of copper foil, aluminum foil and silver foil.

6. The method of one of the preceding claims which is further characterized to include the step of pulling said laminate through a cooling die after it exits said heated forming die.

7. The method of one of the preceding claims wherein said laminate is cut into a plurality of articles of determined length after passing through said cooling die.

8. A method of producing fiber reinforced thermoplastic composite-metallic foil laminated articles comprising: pulling a continuous glass fiber reinforcing material impregnated with a poly(arylene sulfide) thermoplastic material and at least one adjacently positioned continuous metallic foil through a heated forming die in which the entrance cross section is larger than the exit cross section, said die having a temperature such that said thermoplastic material reaches the molten state while passing therethrough whereby a laminate comprised of a glass fiber reinforced poly(arylene sulfide) thermoplastic composite having a metal foil adhered to at least one side thereof is formed; and cutting said laminate into a plurality of articles of determined length.

9. The method of claim 8 wherein said metallic foil is copper foil.

10. The method of one of claims 8 or 9 which is further characterized to include the step of pulling said laminate through a cooling die after said laminate exits said heated forming die and before said laminate is cut into a plurality of articles.

11. The method of one of claims 8 - 10 wherein said temperature of said heated forming die is such that the temperature of said thermoplastic material ranges from a high of from about 350°C to about 400°C to a low of from about 230°C to about 280°C.

12. A method of producing fiber reinforced thermoplastic composite-metallic foil laminated articles comprising:
pulling one or more continuous tapes or sheets of fiber reinforcing material impregnated with a poly(arylene sulfide) thermoplastic material and one or more continuous tapes or sheets of copper foil through a heated forming die in which the entrance cross section is larger than the exit cross section, said die having a temperature such that said thermoplastic material reaches the molten state while passing therethrough whereby a laminate comprised of fiber reinforced thermoplastic composite and copper foil is formed;
pulling said laminate through a cooling die after said laminate has exited said heated forming die; and
cutting said laminate into a plurality of articles of determined length.

13. The method of one of claims 8 - 12 wherein said thermoplastic material is poly(phenylene sulfide).

14. The method of claim 13 wherein said temperature within said heated forming die is such that the temperature of said thermoplastic material reaches a high temperature in the range of from about 350°C to about 400°C.

15. The method of one of claims 8 - 14 wherein said cooling die has a temperature such that said laminate is cooled to a temperature in the range of from about 80°C to about 100°C.

16. A fiber reinforced thermoplastic composite-metallic foil laminate or respectively laminated article produced in accordance with the method of one of the preceding claims.

FIG. 1

FIG. 2

FIG. 3

FIG. 4

FIG. 5

FIG. 6